Europäisches Patentamt

European Patent Office

Office européen des brevets

(11) Publication number: **0 148 083**
**B1**

(12) EUROPEAN PATENT SPECIFICATION

(45) Date of publication of patent specification: **23.05.90**

(21) Application number: **84402696.3**

(22) Date of filing: **21.12.84**

(51) Int. Cl.⁵: **H 01 L 23/498,** H 01 L 23/66

(54) **Ultra-high speed semiconductor integrated circuit device having a multi-layered wiring board.**

(30) Priority: **23.12.83 JP 243410/83**
**27.12.83 JP 249336/83**

(43) Date of publication of application:
**10.07.85 Bulletin 85/28**

(45) Publication of the grant of the patent:
**23.05.90 Bulletin 90/21**

(84) Designated Contracting States:
**DE FR GB**

(56) References cited:
**EP-A-0 101 335**
**FR-A-1 534 329**
**FR-A-2 535 110**
**US-A-4 096 348**

(73) Proprietor: **FUJITSU LIMITED**
**1015, Kamikodanaka Nakahara-ku**
**Kawasaki-shi Kanagawa 211 (JP)**

(72) Inventor: **Fukuta, Masumi**
**1460, Shinkoujimachi**
**Machida-shi Tokyo 194-01 (JP)**
Inventor: **Narita, Hisatoshi**
**920-114, Mogusa**
**Hino-shi Tokyo 191 (JP)**

(74) Representative: **Descourtieux, Philippe et al**
**CABINET BEAU de LOMENIE 55 rue**
**d'Amsterdam**
**F-75008 Paris (FR)**

Courier Press, Leamington Spa, England.

## Description

This invention relates to a semi-conductor integrated circuit device, and, more particularly, to a layout and connecting structure between inner lead terminals of a package and bonding pads on a chip for an ultra-high speed semiconductor integrated circuit device.

As the scale of integration of semiconductor devices increases, the improvement of efficiency and processing speed of the devices becomes consequently more and more important. In the field of ultra-high speed semiconductor IC devices, gallium arsenide (GaAs) is widely used since its carrier mobility is greater than that of silicon. Operating GaAs semiconductor devices at more than 10 gigabits per second (Gbit/s) without difficulty has been reported, but it is still difficult to operate GaAs semiconductor devices at a speed as high as 100 Gbit/s. Also, as the scale of integration increases, the making of interconnections between elements of the device becomes complicated and constitutes a serious problem to resolve for ultra-constitutes a serious problem to resolve for ultra-high speed IC devices.

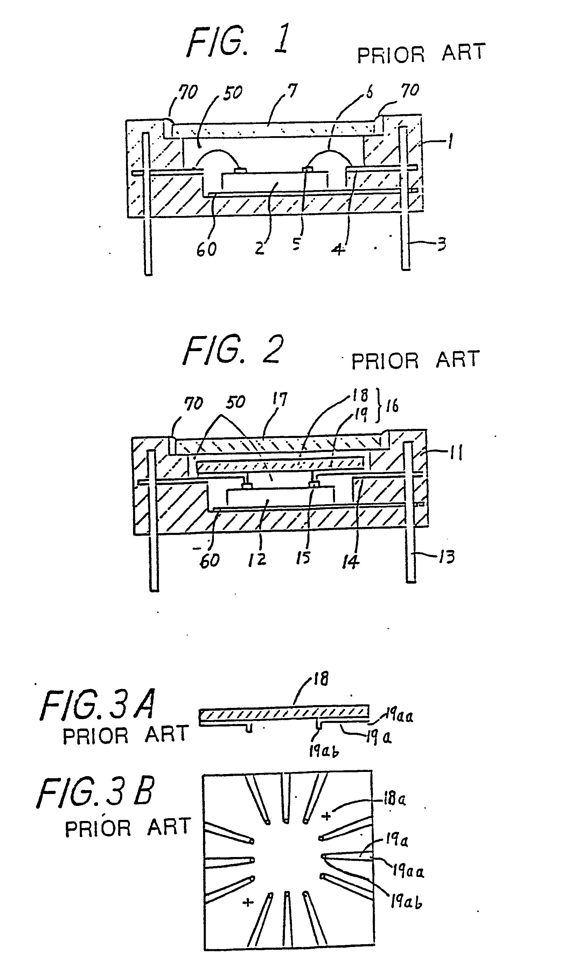

Figures 1 and 2 are schematical cross-sectional views of prior art structures of semiconductor IC devices such as GaAs IC devices. In these figures, reference numerals 1 and 11 designate packages, 2 and 12 are semiconductor chips mounted in the packages 1 and 11, 3 and 13 are outer leads, 4 and 14 are inner lead terminals connected to the outer leads, 5 and 15 are bonding pads, and 7 and 17 are cover plates which cover the packages 1 and 11. The GaAs substrate chip 2, 12 is located in a cavity 50 of the package 1, 11 and is bonded to the ceramic package by means of a low melting point metal sheet 60. The chip size is for example approximately 4 mm square. A hermetic seal 70 is provided for hermetically sealing the cover plate 7, 17 to the package 1, 11.

In the embodiment of figure 1, inner leads 6 are provided for connecting the bonding pads 5 to respective outer leads 3 through the inner lead terminals 4.

In the embodiment of figure 2, a wiring board 16 having a printed wiring circuit is provided for connecting the bonding pads 15 to respective outer leads 13 through the inner lead terminals 14.

Figures 3A and 3B are respectively cross-sectional and bottom plan views of the wiring board 16 of figure 2. This wiring board 16 is arranged above the chip 12 and includes an insulating plate 18, a positioning mark 18a and signal lines 19, 19a. Each signal line has a signal line terminal 19aa connected to a respective inner lead terminal 14 and a projection lead 19ab connected to a respective bonding pad 15.

The increase of the integration scale of the semiconductor device has made the realization of inner leads 6 between the chip and the outer leads 3 more and more complicated.

By using a wiring board such as 16, the wiring of the IC device is simplified. In most prior art devices, multi-lead packages having wiring boards as shown in figure 2 are used.

A study of currently available IC packages in order to develop their performance for operating at ultra-high speed has shown when the operation speed is increased up to ultra-high speeds of approximately 100 Gbit/s, devices having a conventional structure show disadvantages such as large reflection and attenuation of the signal on its transmission lines in the package.

An interconnection structure comprising a silicon substrate and interconnection leads is known from US-A-4096348, the structure being used to test an integrated circuit chip before it is finally assembled.

With reference to an earlier application no. 8217549 in France (FR-A-2535110; filing date: 20.10.82; publication date 27.04.84) the applicant has voluntarily limited the scope of the present application, and submitted separate claims for France.

It is therefore an object of the invention to provide an improved ultra-high speed semiconductor device having a wiring board structure enabling to improve the operation speed while reducing the reflection and transmission line loss at ultra-high operation speed.

The foregoing object is accomplished according to the invention by providing a wiring board comprising a transmission line fabricated on an insulating plate, said transmission line having predetermined transmission characteristics by arranging a signal line conductor and a ground conductor plane with a predetermined spacing therebetween, and said signal line conductor connecting an output terminal of the semiconductor chip to a respective outer lead.

The transmission line is in the form of a coplanar guide or a strip line.

A multi-layer wiring board can be used with through-hole connections. With such a configuration, the output pads of the chip can be positioned at any point on the chip.

By applying the high frequency technology of coplanar guides or strip lines together with impedance matching resistors and wave reforming circuit elements, it is possible to design a wiring board, in particular a multi-layer wiring board, enabling to reduce the reflection and attenuation of the signal resulting from the use of prior art inner lead structures, and which has then an optimum performance for ultra-high speed operation.

These and other features of the invention will become more apparent from the following description taken in connection with the accompanying drawings wherein:

— Figure 1 illustrates schematically a cross-sectional view of a structure of a prior art semiconductor IC device;

— Figure 2 illustrates schematically a cross-sectional view of a structure of a prior art multi-lead semiconductor IC device,

— Figure 3A illustrates schematically a cross-sectional view of the wiring board of the structure shown in Figure 2;

— Figure 3B illustrates schematically a bottom plan view of the wiring board of Figure 3A;

— Figure 4 illustrates schematically a cross-sectional view of an improved ultra-high speed semiconductor IC device according to a first embodiment of the present invention;

— Figure 5A illustrates schematically a cross-sectional view of the wiring board of the device of Figure 4;

— Figure 5B illustrates schematically the bottom plan view of the wiring board of Figure 5A;

— Figure 6A illustrates schematically a cross-sectional view of another structure of the wiring board of the device of Figure 4;

— Figure 6B illustrates schematically the bottom plan view of the wiring board of Figure 6A;

— Figure 7A illustrates schematically a cross-sectional view of still another structure of the wiring board of the device of Figure 4;

— Figure 7B illustrates schematically the bottom plan view of the wiring board of Figure 7A;

— Figure 8A illustrates schematically a cross-sectional view of a further structure of the wiring board of the device of Figure 4;

— Figure 8B illustrates schematically a bottom plan view of the wiring board of Figure 8A;

— Figure 9 illustrates schematically a cross-sectional view of an improved ultra-high speed semiconductor IC device according to a second embodiment of the present invention;

— Figure 10A illustrates schematically a cross-sectional view of a structure of the multi-layered wiring board of the device of Figure 9;

— Figure 10B illustrates schematically the plan view of an upper part of the wiring board of Figure 10A;

— Figure 10C illustrates schematically a plan view of an intermediary part of the wiring board of Figure 10A; and

— Figure 10D illustrates schematically a plan view of a bottom part of the wiring board of Figure 10A.

Same or like reference numerals denote the same or like parts through the drawings.

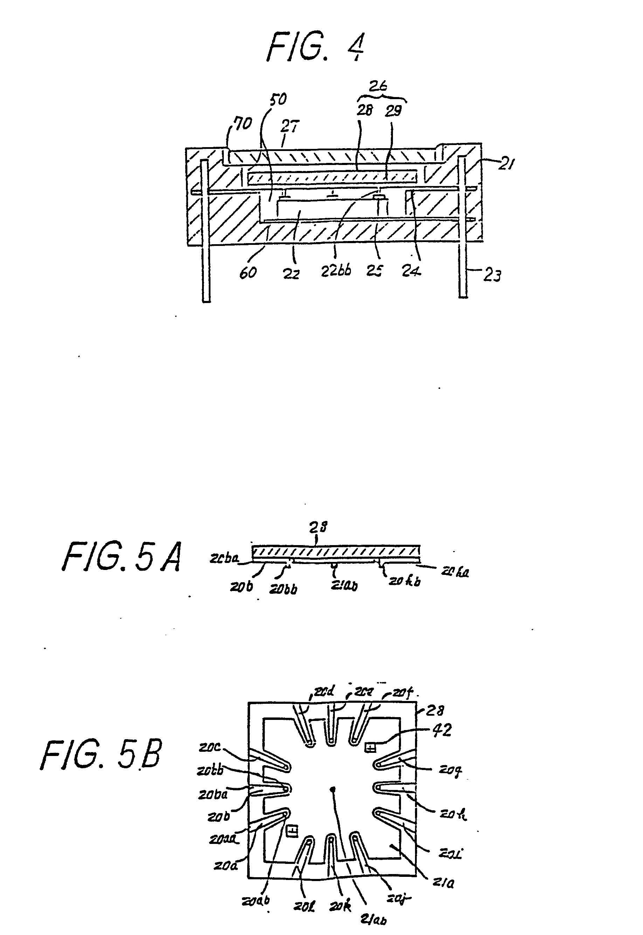

Figure 4 shows a cross-sectional view of an improved ultra-high speed semiconductor IC device according to a first embodiment of the invention.

An IC chip 22 is mounted in the cavity 50 of a package 21 by means of a low melting point metal sheet 60. Each of the pads 25 on the chip 22 is connected by a signal line 29 to respective outer lead 23 through an inner lead terminal 24 of the package 21. The chip 22 has a size of for example approximately 4 mm square, and is connected to the ground through the low melting point metal sheet 60 and an outer lead (not shown). The package 21 is covered by a cover plate 27 which is sealed hermetically to the package by a seal 70.

The signal lines 29 are formed on a wiring board 26 which comprises a sapphire plate 28 and is arranged over the chip 22. The spacing between the bottom of the wiring board 26 having the signal lines 29 and the surface of the chip 22 has a value for example comprised between 30 μm and 50 μm. The spacing is a critical factor and must be uniform in order to keep constant the characteristic impedance of the transmission lines and to reduce the reflection of signal. The pads 25 are connected to projection leads of the signal lines which are made of gold. The bonding connection is realized by a known process, such as for example ball bonding or flip tip bonding.

The processes and technology used for assembling the constitutive parts of the device of figure 4 are processes and technology conventionally used in the making of semiconductor IC device, such as bonding, metal sputtering, mounting technology, etc... Therefore, the detailed description of such processes and technology will be omitted in the following disclosure for sake of simplicity.

A detailed structure of an embodiment of the wiring board 26 having signal lines in the form of coplanar guides will now be described with respect to figures 5A and 5B. The board 26 is made of a sapphire plate 28, for example, and the signal lines 20a to 201 are patterned by metallic conductors formed on the bottom of the sapphire plate 28. The conductors are, for example, made of gold, silver or copper. As shown in figure 5B, the conductors 20a, 20b,..., 201 are shielded by a grounded conductor 21a providing a coplane guide structure. Conductor 21a is grounded through a projection lead 21ab.

Thus, the wiring board 26 has a structure showing a significant difference compared to the structure of prior art wiring boards. By adapting the coplanar guide structure to the wiring board, it is possible to reduce the reflection of signal and the attenuation of the transmission lines for ultra-high speed IC device, and thus enable the signals on the pads 25 to be transferred to the outer leads 23 through the transmission lines without substantial transmission loss.

On the tips of the signal lines 20a, 20b,..., 201 are provided projection leads 20ab, 20bb,..., 201b and, at the other ends of the signal lines are provided signal line terminals 20aa, 20ba,..., 201a. The projection leads 20ab to 201b are bonded to respective pads 25 and the signal line terminals 20aa to 201a are bonded to respective inner lead terminals 24 when the wiring board 26 is placed in position.

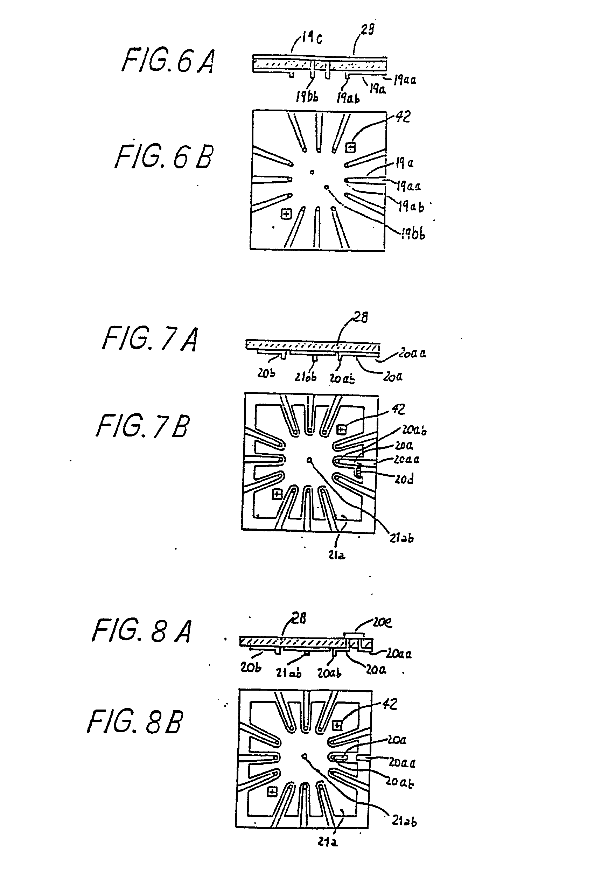

Figures 6A and 6B show another embodiment of a wiring board 26 with transmission lines in the form of strip lines. Lines 19a similar to the lines 20a to 201 of the embodiment of figures 5A, 5B are formed on the lower surface of the plate 28. Each line 19a has a projection lead 19ab, at one end and line terminal 19aa at the other end. A conductor 19c is formed on the upper surface of the plate 28 and is grounded by means of a projection lead 19bb extending through the plate 28.

The plate 28 with the conductive surfaces formed on its lower and upper sides constitutes a strip line. For a further description of a strip line, commonly known as a wave guide, reference is made to a report entitled "Microwave Integrated Circuits" by Gupta, K.C. and Singh, A in John Wiley & Sons (1974) which disclosed a strip line on the same principle as the one hereinabove mentioned. According to this report, the optimum value of the impedance of a strip line is defined from the dielectric constant of the insulator, the thickness of the insulator and the width of the strip line. Therefore, in order to obtain an optimum value of the impedance $Z_0$ equal, for example, to 50 ohms, the condition $W / h = 0.9$ must be met, where W is the width of strip line and h is the thickness of the sapphire plate (specific inductive capacity of sapphire $E_r$ is 10.55). As a result, the thickness of the sapphire plate 28 is chosen approximately 0.1 mm and the width of the strip line is selected to be 0.09 mm. So, the signals applied to the projection lead 19ab, are transferred to the signal line terminals 19aa through the signal lines 19a without transmission loss.

Another embodiment of the wiring board is illustrated by figures 7A and 7B. This embodiment only differs from the one of figures 5A, 5B by the provision of an impedance matching resistor 20d connected between the line 20a and the grounded conductor 21a.

All semiconductor devices and particularly those intended for operation at high frequency, require a suitable impedance matching to the output circuits in order to provide enough output power. The impedance matching between package leads is also important to the reflection of the signal through the signal lines. With any output devices the power output varies as the load impedance varies. By using a wiring board with a signal line 20a loaded by an impedance matching resistor 20d in parallel, the output impedance is matched to the lead by the matching resistor 20d, to be for example equal to 50 ohms. Thus, the signal applied to the projection lead 20ab is transferred to the signal terminal 20aa through the line 20a without transmission loss.

Still another embodiment of the wiring board is illustrated by figures 8A and 8B. This embodiment differs from the one of figures 5A and 5B in that the wiring board is provided with a circuit element 20e for wave reforming.

The wave reforming element 20e is mounted on the upper surface of the sapphire plate 28 and is connected in series with the signal line 20a, through the plate 28. Semiconductor devices intended for operation at ultra-high frequency may need reforming circuits such as 20e. In the case, for example, of nonlinear distorsion of the signal on the transmission line, the wave reforming circuit 20e, in the form of an IC, is designed to compensate for the transmission loss due to the non-linear distorsion. Also, as in the case of the above-mentioned resistor, or as capacitors or other components, the reforming IC 20e can be stacked to offer an increased or decreased impedance, an increased output, etc... A desired characteristic being the direct proportionality between the input signal wave form and that of the output, the use of wiring boards having wave reforming circuits makes it possible to reform the signals received from the projection leads 20ab and reduce the distorsion.

In all the above described embodiments of the wiring board, through-holes 42 are formed through the plate 48 to see positioning marks + on the chip in order to ensure a proper positioning of the wiring board over the chip.

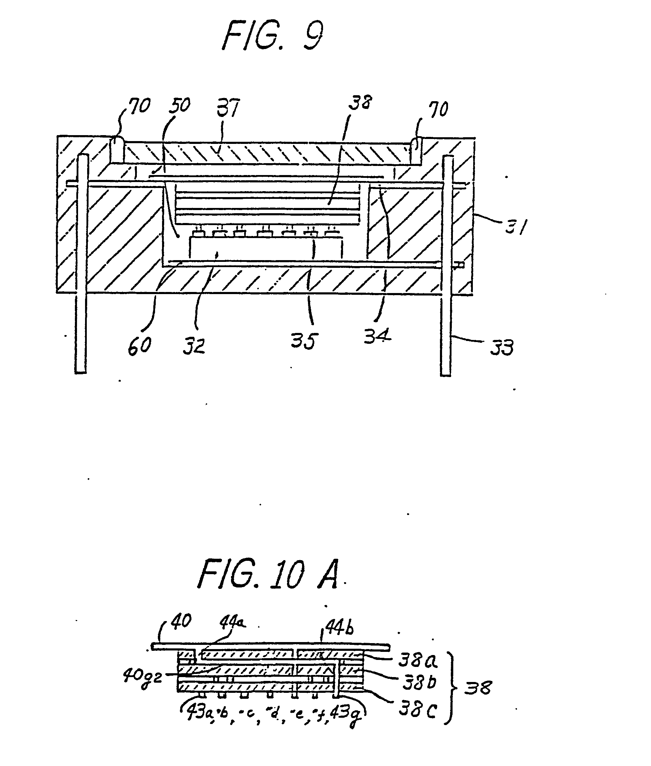

Figures 9 to 10D illustrate another embodiment of a device according to the invention having a multi-layered wiring board. Same or like reference numerals denote same or like parts in these figures.

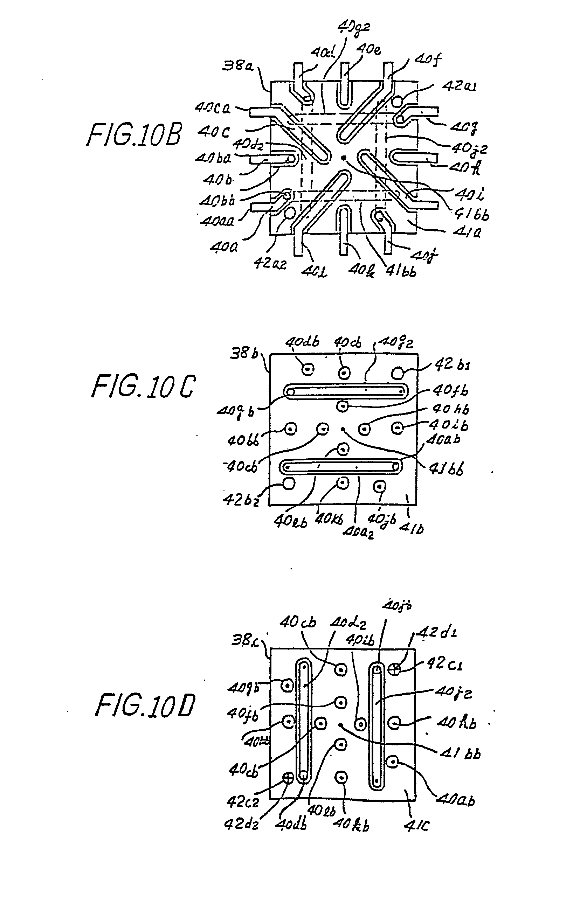

By contrast with the hereinabove described wiring boards, the wiring board 38 of figures 9 and 10A has a multi-layered structure. The use of a multi-layered wiring board makes it possible to simplify the wiring of the chip as the integration scale of the IC device increases, because it is then possible to reduce the connecting area between circuit elements on the chip.

As shown in figure 10A, the multi-layered wiring board 38 is composed of a plurality of insulating plates 38a, 38b and 38c in the form of sapphire plates, for example. Though a three-layer wiring board is illustrated, it will be obvious that the number of layers can be chosen different from three. Each of the sapphire plates 38a, 38b, 38c has a patterned metallic conductor plane film made of gold, silver or copper, for example. The signal lines $40g_2$ and the grounding conductors 41bb are formed respectively on the sapphire plates 38a, 38b and 38c. The patterned sapphire plates 38a, 38b and 38c are stacked up and fused to form the multi-layered wiring board 38. The stacked board 38 includes a signal line terminal 40 and projection leads 43a, 43b,...,43g through hole connection leads 44a, 44b.

Figure 10B shows schematically a plan view of the upper surface of the upper wiring board 38a. The patterned metallic films on the wiring board 38a are used for the signal lines 40a, 40b,..., 40l having respective signal line terminal leads 40aa, 40ba,...40la and for the grounded metallic conductor 41a. Each of the signal line terminal leads 40aa, 40ba,...,40la projects out from the plate 38a for connection to a respective inner lead terminal 34 of the package 31 (figure 9). The inner lead terminals 34 are connected to the outer leads 33. Dot lines $40a_2$, $40g_2$ and $40d_2$, $40j_2$ designate the signal lines which are respectively fabricated on the plate 38b and the plate 38c shown in figure 10 and figure 10D. The wiring plate 38a also includes through-holes $42a_1$ and $42a_2$ in order to see positioning marks (+) on the chip.

Figure 10C illustrates schematically a plan view of the wiring pattern on the intermediary wiring sapphire plate 38b. The metallic pattern in this example includes a grounded metallic conductor 41b and strip signal lines $40a_2$ and $40g_2$. A projection lead connecting hole, respectively 40ab and 40gb is formed at one end of each of the signal lines $40a_2$ and $40g_2$. Moreover, the plate 38b further includes through-holes 40bb, 40cb,...,401b to enable interconnection between the upper plate 38a and the lower plate 38c by through-hole connection. Additional through-holes 42b$_1$ and 42b$_2$ are provided in order to see the positioning marks on the chip.

Figure 10D illustrates schematically a plan view of the metallic pattern on the lower wiring plate 38c. The pattern and material of the plate 38c are similar to the ones of the plate 38b shown in figure 10C. The metallic pattern includes strip lines 40d$_2$ and 40j$_2$ and, a grounded conductor 41c. Projection lead connecting holes 40db and 40jb are formed at respective ends of the signal lines 40d$_2$ and 40j$_2$. The plate 38c also includes projection lead connecting holes 40ab, 40bb,... 401b and through-holes 42c$_1$ and 42c$_2$ for seeing the positioning marks (+) on the chip.

Conductors 41a, 41b and 41c are connected to the ground by means of through-hole connection 41bb (figures 10A to 10D).

The plates 38a, 38b and 38c are assembled together with the through-holes 42a$_1$, 42b$_1$ and 42c$_1$ aligned, as well as the through-holes 42a$_2$, 42b$_2$ and 42c$_2$. The multi-layered wiring board 38 is positioned over the chip to align these two series of through-holes with respective positioning marks (+) 42d$_1$ and 42d$_2$ (shown in figure 10D only) provided on the chip.

The connection from the upper wiring plate 38a to the lower wiring plate 38c is formed by through-hole connection. For example, the signal line 40a provided on the upper wiring plate 38a is connected to the signal line 40a$_2$ on the intermediary wiring plate 38b by means of the projection lead 44a (figure 10A) through the hole connection 40bb. Similarly, the signal line 40a$_2$ is connected to the projection lead 44b through the projection lead hole 40ab. Finally, the projection lead 43g (shown in figure 10A) is connected to a respective bonding pad of the chip.

Similarly, the connections between the sapphire plate 38c and the bonding pads are accomplished by means of the projecting leads 43a, 43b,..., 43g, through the projection lead holes 40ab, 40hb, 40jb, 40kb, 40db, 40gb and 40bb. Furthermore, it is possible to have the wirings between the signal lines to cross each other and, in particular, the output pads 35 can be set in any position on the chip 32. This enables to reduce the connecting area between circuit elements on the chip, so that the integration scale of the semiconductor IC device can be increased. As a result, the invention allows the design of a wiring board having an optimum performance for ultra-high speed operation for high density integrated circuit devices. For example, using a multi-layered wiring board such as described hereinbefore, an operation speed of approximately 100 Gbit/s has been attained.

Although only ultra-high speed GaAs semiconductor devices have been mentioned, it is obvious that the invention can be applied to other semiconductor devices.

**Claims for the contracting states: DE, GB**

1. A semiconductor integrated circuit device comprising:
   a semiconductor chip (22; 32) having an output terminal and mounted in a package (21; 31);
   an outer lead (23; 33) positioned on said package; and
   a wiring board (26; 38) interconnecting between said semiconductor chip and said outer lead;
   characterized in that: said wiring board (26; 38) comprises a transmission line fabricated on an insulating plate (28; 38a, 38b, 38c), said transmission line having predetermined transmission characteristics by arranging a signal line conductor and a ground conductor plane with a predetermined spacing therebetween, and said signal line conductor interconnecting between an output terminal (25; 35) of said semiconductor chip and said outer lead (23; 33).

2. A semiconductor integrated circuit device according to claim 1, wherein said transmission line is in the form of coplanar guide, which comprises a signal line conductor (20a, 20b,...) and a ground conductor (21a) formed on a common surface of said insulating plate (28).

3. A semiconductor integrated circuit device according to claim 1, wherein said transmission line is in the form of strip line structure which comprises a signal line conductor (19a) formed on bottom side of said insulating plate (28) and a ground conductor (19c) formed on upper side of said insulating plate.

4. A semiconductor integrated circuit device according to any one of claims 1 to 3, characterized in that said transmission line has an impedance matching resistor (20d) which is mounted on the insulating plate (28).

5. A semiconductor integrated circuit device according to any one of claims 1 to 3, characterized in that said transmission line has a wave forming circuit (20e) which is loaded on the insulating plate (28), and coupled to said signal line conductor (20a).

6. A semiconductor integrated circuit device according to any one of claims 1 to 5, characterized in that said wiring board comprises a multi-layered wiring board (38).

7. A semiconductor integrated circuit device according to claim 6, characterized in that said multi-layered wiring board has a plurality of insulating plates (38a, 38b, 38c) and a plurality of levels of signal line conductors, said signal line conductors being interconnected through holes formed in each insulating plate and said insulating plates being piled one above the other.

**Claims for the contracting state: FR**

1. A semiconductor integrated circuit device comprising:
   a semiconductor chip (32) having an output terminal and mounted in a package (31);
   an outer lead (33) positioned on said package;

and

a wiring board (38) interconnecting between said semiconductor chip and said outer lead;

said wiring board (38) comprising a transmission line fabricated on an insulating plate, said transmission line having predetermined transmission characteristics by arranging a signal line conductor and a ground conductor plane with a predetermined spacing therebetween, and said signal line conductor interconnecting between an output terminal (35) of said semiconductor chip and said outer lead (33),

characterized in that said wiring board (38) comprises a multi-layered wiring board.

2. A semiconductor integrated circuit device according to claim 1, characterized in that said multi-layered wiring board has a plurality of insulating plates (38a, 38b,...) and a plurality of levels of signal line conductors, said signal line conductors being interconnected through holes formed in each insulating plate and said insulating plates being piled one above the other.

3. A semiconductor integrated circuit device according to claim 2, wherein said transmission line is in the form of coplanar guide, which comprises a signal line conductor (40a, 40b,...) and a ground conductor (41a, 41b,...) formed on a common surface of said insulating plate (38a, 38b,...).

4. A semiconductor integrated circuit device according to claim 2, wherein said transmission line is in the form of strip line structure which comprises a signal line conductor formed on bottom side of said insulating plate (38a, 38b,...) and a ground conductor formed on upper side of said insulating plate.

5. A semiconductor integrated circuit device comprising:

a semiconductor chip (22) having an output terminal and mounted in a package (21);

an outer lead (23) positioned on said package; and

a wiring board (26) interconnecting between said semiconductor chip and said outer lead;

said wiring board (26) comprising a transmission line fabricated on an insulating plate (28), said transmission line having predetermined transmission characteristics by arranging a signal line conductor and a ground conductor plane with a predetermined spacing therebetween, and said signal line conductor interconnecting between an output terminal (25) of said semiconductor chip and said outer lead (23),

characterized in that said transmission line is in the form of strip line structure which comprises a signal line conductor (19a) formed on bottom side of said insulating plate (28) and a ground conductor (19c) formed on upper side of said insulating plate.

6. A semiconductor integrated circuit device according to any one of claims 1 to 5, characterized in that said transmission line has an impedance matching resistor (20d) which is mounted on the insulating plate (28; 38a, 38b,...).

7. A semiconductor integrated circuit device according to any one of claims 1 to 5, characterized in that said transmission line has a wave forming circuit (20e) which is loaded on the insulating plate (28; 38a, 38b,...), and coupled to said signal line conductor (20a; 40a, 40b,...).

**Patentansprüche für die Vertragsstaaten: DE, GB**

1. Integrierte Halbleiterschaltungsvorrichtung mit:

einem Halbleiterchip (22; 32), das einen Ausgangsanschluss hat und in einer Packung (21; 31) montiert ist;

einer äusseren Leitung (23; 33), die auf der genannten Packung positioniert ist; und

einer Verdrahtungskarte (26; 38), die das genannte Halbleiterchip und die genannte äussere Leitung miteinander verbindet, dadurch gekennzeichnet, dass:

die genannte Verdrahtungskarte (26; 38) eine Transmissionsleitung umfasst, die auf einer isolierenden Platte (28; 38a, 38b, 38c) hergestellt ist, welche Transmissionsleitung, durch Anordnen eines Signalleitungsleiters und einer Grundleitungsebene mit einem vorbestimmten Abstand dazwischen, vorbestimme Transmissionscharakteristiken hat und bei welcher der genannte Signalleitungsleiter einen Ausgangsanschluss (25; 35) des genannten Halbleiterchip und die genannte äussere Leitung (23; 33) miteinander verbindet.

2. Integrierte Halbleiterschaltungsvorrichtung nach Anspruch 1, bei der die genannte Transmissionsleitung in der Form einer koplanaren Leitung ist, welche einen Signalleitungsleiter (20a, 20b,...) und einen Erdleiter (21a) umfasst, die auf einer gemeinsamen Oberfläche der genannten isolierenden Platte (28) gebildet sind.

3. Integrierte Halbleiterschaltungsvorrichtung nach Anspruch 1, bei der die genannte Transmissionsleitung in Form einer Streifenleitungsstruktur ist, welche einen Signalleitungsleiter (19a) umfasst, der auf der Unterseite der genannten isolierenden Platte (28) geformt ist, und einen Erdleiter (19c), der auf der oberen Seite der genannten isolierenten Platte geformt ist.

4. Integrierte Halbleiterschaltungsvorrichtung nach einem der Ansprüche 1 bis 3, dadurch gekennzeichnet, dass die genannte Transmissionsleitung einen Impedanzanpassungswiderstand (20d) hat, der auf der isolierenden Platte (28) montiert ist.

5. Integrierte Halbleiterschaltungsvorrichtung nach einem der Ansprüche 1 bis 3, dadurch gekennzeichnet, dass die genannte Transmissionsleitung eine Wellenformerschaltung (20e) hat, die auf der isolierenden Platte (28) geladen und mit dem Signalleitungsleiter (20a) verbunden ist.

6. Integrierte Halbleiterschaltungsvorrichtung nach einem der Ansprüche 1 bis 5, dadurch gekennzeichnet, dass die genannte Verdrahtungskarte eine vielschichtige Verdrahtungskarte (38) umfasst.

7. Integrierte Halbleiterschaltungsvorrichtung nach Anspruch 6, dadurch gekennzeichnet, dass die genannte vielschichtige Verdrahtungskarte eine Vielzahl von isolierenden Platten (38a, 38b, 38c) und eine Vielzahl von Pegeln von Signalleitungsleitern hat, welche genannten Signalleitungsleiter durch Löcher miteinander verbunden sind, die in jeder isolierenden Platte geformt sind, und welche genannten isolierenden Platten eine über der anderen gestapelt sind.

**Patentansprüche für den Vertragsstaat: FR**

1. Integrierte Halbleiterschaltungsvorrichtung mit:

einem Halbleiterchip (32), das einen Ausgangsanschluss hat und in einer Packung (31) montiert ist;

einer äusseren Leitung (33), die auf der genannten packung positioniert ist; und

einer Verdrahtungskarte (38), die das genannte Halbleiterchip und die genannte äussere Leitung miteinander verbindet,

wobei die genannte Verdrahtungskarte (38) eine Transmissionsleitung umfasst, die auf einer isolierenden Platte hergestellt ist, welche Transmissionsleitung, durch Anordnen eines Signalleitungsleiters und einer Grundleitungsebene mit einem vorbestimmten Abstand dazwischen, vorbestimme Transmissionscharakteristiken hat, und wobei der genannte Signalleitungsleiter einen Ausgangsanschluss (35) des genannten Halbleiterchip und die genannte äussere Leitung (33) miteinander verbindet,

dadurch gekennzeichnet, dass die genannte Verdrahtungskarte (38) eine vielschichtige Verdrahtungskarte umfasst.

2. Integrierte Halbleiterschaltungsvorrichtung nach Anspruch 1, dadurch gekennzeichnet, dass die genannte vielschichtige Verdrahtungskarte eine Vielzahl von isolierenden Platten (38a, 38b,...) und eine Vielzahl von Pegeln von Signalleitungsleitern hat, welche genannten Signalleitungsleiter durch Löcher miteinander verbunden sind, die in jeder isolierenden Platte geformt sind, und welche genannten isolierenden Platten eine über der anderen gestapelt sind.

3. Integrierte Halbleiterschaltungsvorrichtung nach Anspruch 2, bei der die genannte Transmissionsleitung in der Form einer koplanaren Leitung ist, welche einen Signalleitungsleiter (40a, 40b,...) und einen Erdleiter (41a, 41b,...) umfasst, die auf einer gemeinsamen Oberfläche der genannten isolierenden Platte (38a, 38b,...) gebildet sind.

4. Integrierte Halbleiterschaltungsvorrichtung nach Anspruch 1, bei der die genannte Transmissionsleitung in Form einer Streifenleitungsstruktur ist, welche einen Signalleitungsleiter umfasst, der auf der Unterseite der genannten isolierenden Platte (38a, 38b,...) geformt ist, und einen Erdleiter, der auf der oberen Seite der genannten isolierenden Platte geformt ist.

5. Integrierte Halbleiterschaltungsvorrichtung mit:

einem Halbleiterchip (22), das einen Ausgangsanschluss hat und in einer Packung (21) montiert ist;

einer äusseren Leitung (23), die auf der genannten Packung positioniert ist; und

einer Verdrahtungskarte (26), die das genannte Halbleiterchip und die genannte äussere Leitung miteinander verbindet,

wobei die genannte Verdrahtungskarte (26) eine Transmissionsleitung umfasst, die auf einer isolierenden Platte (28) hergestellt ist, welche Transmissionsleitung, durch Anordnen eines Signalleitungsleiters und einer Grundleitungsebene mit einem vorbestimmten Abstand dazwischen, vorbestimme Transmissionscharakteristiken hat, und wobei der genannte Signalleitungsleiter einen Ausgangsanschluss (25) des genannten Halbleiterchip und die genannte äussere Leitung (23) miteinander verbindet,

dadurch gekennzeichnet, dass die genannte Transmissionsleitung in Form einer Streifenleitungsstruktur ist, welche einen Signalleitungsleiter (19a) umfasst, der auf der Unterseite der genannten isolierenden Platte (28) geformt ist, und einen Erdleiter (19c), der auf der oberen Seite der genannten isolierenden Platte geformt ist.

6. Integrierte Halbleiterschaltungsvorrichtung nach einem der Ansprüche 1 bis 5, dadurch gekennzeichnet, dass die genannte Transmissionsleitung einen Impedanzanpassungswiderstand (20d) hat, der auf der isolierenden Platte (28; 38a, 38b,...) montiert ist.

7. Integrierte Halbleiterschaltungsvorrichtung nach einem der Ansprüche 1 bis 5, dadurch gekennzeichnet, dass die genannte Transmissionsleitung eine Wellenformerschaltung (20e) hat, die auf der isolierenden Platte (28; 38a, 38b,...) geladen und mit dem Signalleitungsleiter (20a; 40a, 40b,...) verbunden ist.

**Revendications pour les Etats Contractants: DE GB**

1. Dispositif à circuit intégré semiconducteur, comprenant:

une puce semiconductrice (22; 32) possédant une borne de sortie et montée dans un boîtier (21; 31);

un fil externe (23; 33) placé sur ledit boîtier; et

une plaquette de câblage (26; 38) assurant l'interconnexion entre ladite puce semiconductrice et ledit fil externe;

caractérisé en ce que:

ladite plaquette de câblage (26; 38) comprend une ligne de transmission fabriquée sur une plaque isolante (28; 38a, 38b, 38c), ladite ligne de transmission ayant des caractéristiques de transmission prédéterminées du fait qu'on dispose un conducteur de ligne de signal et un plan conducteur de mise à la terre avec un écartement mutuel prédéterminé, ledit conducteur de ligne de signal assurant l'interconnexion entre une borne de sortie (25; 35) de ladite puce semiconductrice et ledit fil externe (23; 33).

2. Dispositif à circuit intégré semiconducteur selon la revendication 1, où ladite ligne de transmission se présente sous la forme d'un guide coplanaire, qui comprend un conducteur de ligne de signal (20a, 20b,...) et un conducteur de mise à la terre (21a) formés sur une surface commune de ladite plaque isolante (28).

3. Dispositif à circuit intégré semiconducteur selon la revendication 1, où ladite ligne de transmission se présente sous la forme d'une structure de ligne à bandes, qui comprend un conducteur de ligne de signal (19a) formé sur le côté inférieur de ladite plaque isolante (28) et un conducteur de mise à la terre (19c) formé sur le côté supérieur de ladite plaque isolante.

4. Dispositif à circuit intégré semiconducteur selon l'une quelconque des revendications 1 à 3, caractérisé en ce que ladite ligne de transmission possède une résistance d'adaptation d'impédance (20d) qui est montée sur la plaque isolante (28).

5. Dispositif à circuit intégré semiconducteur selon l'une quelconque des revendications 1 à 3, caractérisé en ce que ladite ligne de transmission possède un circuit de mise en forme de l'onde (20e) qui est chargé sur la plaque isolante (28) et est couplé audit conducteur de ligne de signal (20a).

6. Dispositif à circuit intégré semiconducteur selon l'une quelconque des revendications 1 à 5, caractérisé en ce que ladite plaquette de câblage consiste en une plaquette de câblage multicouche (38).

7. Dispositif à circuit intégré semiconducteur selon la revendication 6, caractérisé en ce que ladite plaquette de câblage multicouche possède plusieurs plaques isolantes (38a, 38b, 38c) et plusieurs niveaux de conducteurs de ligne de signal, lesdits conducteurs de ligne de signal étant interconnectés par l'intermédiaire de trous formés dans chaque plaque isolante et lesdites plaques isolantes étant empilées les unes au-dessus des autres.

**Revendications pour l'Etat Contractant: FR**

1. Dispositif à circuit intégré semiconducteur, comprenant:
une puce semiconductrice (32) possédant une borne de sortie et montée dans un boîtier (31);
un fil externe (33) placé sur ledit boîtier; et
une plaquette de câblage (38) assurant l'interconnexion entre ladite puce semiconductrice et ledit fil externe;
ladite plaquette de câblage (38) comprenant une ligne de transmission fabriquée sur une plaque isolante, ladite ligne de transmission ayant des caractéristiques de transmission prédéterminées du fait qu'on dispose un conducteur de ligne de signal et un plan conducteur de mise à la terre avec un écartement mutuel prédéterminé, ledit conducteur de ligne de signal assurant l'interconnexion entre une borne de sortie (35) de ladite puce semiconductrice et ledit fil externe (33),
caractérisé en ce que ladite plaquette de câblage (38) consiste en une plaquette de câblage multicouche.

2. Dispositif à circuit intégré semiconducteur selon la revendication 1, caractérisé en ce que ladite plaquette de câblage multicouche possède plusieurs plaques isolantes (38a, 38b, ...) et plusieurs niveaux de conducteurs de ligne de signal, lesdits conducteurs de ligne de signal étant interconnectés par l'intermédiaire de trous formés dans chaque plaque isolante et lesdites plaques isolantes étant empilées les unes au-dessus des autres.

3. Dispositif à circuit intégré semiconducteur selon la revendication 2, où ladite ligne de transmission se présente sous la forme d'un guide coplanaire, qui comprend un conducteur de ligne de signal (40a, 40b,...) et un conducteur de mise à la terre (41a, 41b,...) formés sur une surface commune de ladite plaque isolante (38a, 38b,...).

4. Dispositif à circuit intégré semiconducteur selon la revendication 2, où ladite ligne de transmission se présente sous la forme d'une structure de ligne à bandes, qui comprend un conducteur de ligne de signal formé sur le côté inférieur de ladite plaque isolante (38a, 38b,...) et un conducteur de mise à la terre formé sur le côté supérieur de ladite plaque isolante.

5. Dispositif à circuit intégré semiconducteur, comprenant:
une puce semiconductrice (22) possédant une borne de sortie et montée dans un boîtier (21);
un fil externe (23) placé sur ledit boîtier; et
une plaquette de câblage (26) assurant l'interconnexion entre ladite puce semiconductrice et ledit fil externe;
ladite plaquette de câblage (26) comprenant une ligne de transmission fabriquée sur une plaque isolante (28), ladite ligne de transmission ayant des caractéristiques de transmission prédéterminées du fait qu'on dispose un conducteur de ligne de signal et un plan conducteur de mise à la terre avec un écartement mutuel prédéterminé, ledit conducteur de ligne de signal assurant l'interconnexion entre une borne de sortie (25) de ladite puce semiconductrice et ledit fil externe (23),
caractérisé en ce que ladite ligne de transmission se présente sous la forme d'une structure de ligne à bandes, qui comprend un conducteur de ligne de signal (19a) formé sur le côté inférieur de ladite plaque isolante (28) et un conducteur de mise à la terre (19c) formé sur le côté supérieur de ladite plaque isolante.

6. Dispositif à circuit intégré semiconducteur selon l'une quelconque des revendications 1 à 5, caractérisé en ce que ladite ligne de transmission possède une résistance d'adaptation d'impédance (20d) qui est montée sur la plaque isolante (28; 38a, 38b,...).

7. Dispositif à circuit intégré semiconducteur selon l'une quelconque des revendications 1 à 5, caractérisé en ce que ladite ligne de transmission possède un circuit de mise en forme de l'onde (20e) qui est chargé sur la plaque isolante (28, 38a, 38b,...) et est couplé audit conducteur de ligne de signal (20a; 40a, 40b,...).

## FIG. 1 PRIOR ART

## FIG. 2 PRIOR ART

## FIG. 3 A PRIOR ART

## FIG. 3 B PRIOR ART

1

# FIG. 4

# FIG. 5A

# FIG. 5B

FIG. 6 A

FIG. 6 B

FIG. 7 A

FIG. 7 B

FIG. 8 A

FIG. 8 B

# FIG. 9

# FIG. 10 A

FIG.10B

FIG.10 C

FIG.10 D